# FASCICULE DE BREVET EUROPEEN

(11) **EP 1 053 592 B1**
(45) Date de publication et mention de la délivrance du brevet: **22.09.2004**
(21) Numéro de dépôt: 99958258.8
(22) Date de dépôt: 07.12.1999
(51) Int. Cl.: H03H 3/08, H03H 9/05

(54) **COMPOSANT A ONDES DE SURFACE ENCAPSULE ET PROCEDE DE FABRICATION COLLECTIVE**
UMHÜLLTES OBERFLÄCHENWELLEN-BAUELEMENT UND MASSENHERSTELLUNGSVERFAHREN
ENCAPSULATED SURFACE WAVE COMPONENT AND COLLECTIVE METHOD FOR MAKING SAME

(30) Priorité: 08.12.1998 FR 9815478
(43) Date de publication de la demande: 22.11.2000
(73) Titulaire: Thales, 75008 Paris (FR)
(72) Inventeur: BIDARD, Agnès, Thomson-CSF Prop. Intellectuelle, 94117 Arcueil Cedex (FR); BUREAU, Jean-Marc Thomson-CSF Prop. Intellectuelle, 94117 Arcueil Cedex (FR)
(86) Numéro de dépôt international: PCT/FR1999/003036
(87) Numéro de publication internationale: WO 2000/035085

(56) Documents cités:
- DE-A- 3 937 870
- GB-A- 2 171 850

## Description

Le domaine de l'invention est celui des dispositifs à ondes acoustiques de surface et notamment celui des filtres encore dénommés SAW (Surface Acoustic Wave) qui permettent de filtrer de manière très sélective des bandes de fréquence. Un tel dispositif est connu p.ex.du document DE3937870A1. Destinés à des équipements portables tels que le radiotéléphone, la miniaturisation de ces composants et de leur boîtier de protection, est essentielle.

Par ailleurs, comme les ondes acoustiques se propagent à proximité de la surface du substrat piézo-électrique, cette surface doit être laissée libre pour ne pas perturber la propagation des ondes, ce qui constitue une contrainte supplémentaire au niveau des boîtiers d'encapsulation.

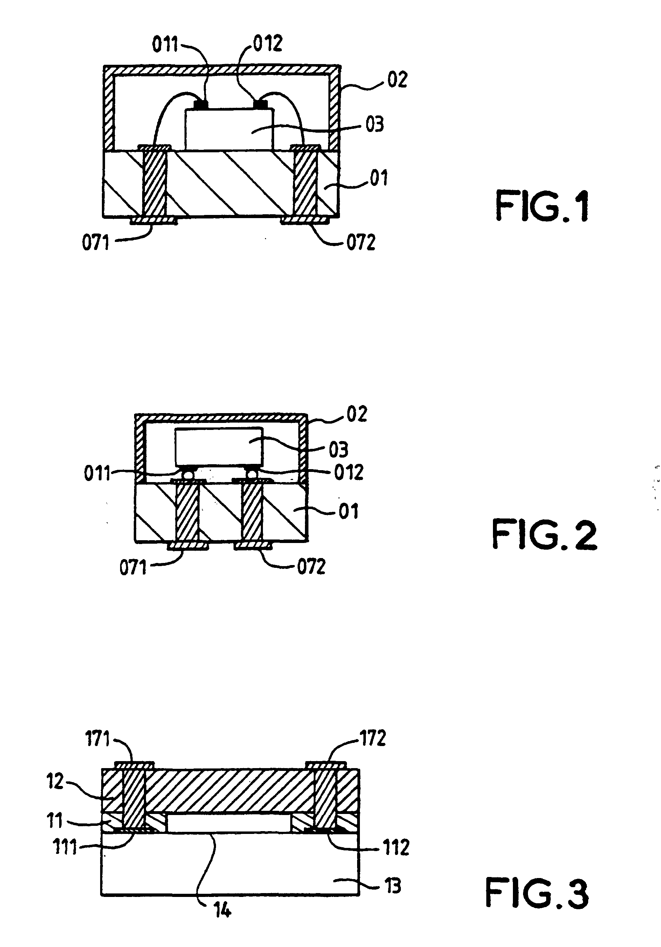

Les technologies actuelles d'encapsulation des filtres à ondes de surface reposent sur un boîtier en deux parties comme illustré en figure 1 : une embase céramique ou organique 01, et un couvercle céramique, métallique ou organique 02, dont la fermeture par soudure ou par collage assure l'herméticité du composant tout en ménageant la cavité nécessaire. Dans ce type de boîtier, les dispositifs à ondes de surface (DOS) 03, peuvent être assemblés par collage sur l'embase. Les connexions électriques entre les plots internes 011, 012 du DOS et des plots externes 071 et 072 sont assurées par des vias métallisés au travers de l'embase 01.

La figure 1 illustre un exemple de l'art antérieur, dans lequel les connexions électriques du DOS avec l'extérieur sont de type fil. Pour assurer une meilleure compacité, la technique de type point (« flip chip », le composant étant retourné) est actuellement employée. La figure 2 illustre un exemple de DOS encapsulé selon l'art connu, qui constitue une variante de la figure 1.

Afin de répondre aux besoins de grands marchés consommateurs (radiotéléphonie, automobile ...), les nouvelles technologies d'encapsulation doivent rendre les filtres de plus en plus petits, tout en diminuant les coûts de fabrication. Comme pour d'autres composants, la tendance est à la réduction toujours plus grande de l'encombrement des boîtiers, pour aboutir à un assemblage composant/boîtier d'encapsulation dont la surface est égale à celle de la puce seule.

La présente invention répond à ces exigences en proposant un dispositif à ondes de surface dans une cavité étanche comportant un micro-capot uniquement sur le substrat piézoélectrique sans en augmenter la surface.

Plus précisément, l'invention a pour objet un composant à ondes de surface, comprenant au moins un dispositif à ondes de surface encapsulé dans un boîtier, ledit dispositif étant réalisé à la surface d'un substrat piézo-électrique au moyen d'électrodes interdigitées alimentée par des premiers plots conducteurs internes à la surface du substrat, caractérisé en ce que le boîtier comporte, outre le substrat :
- une première couche en résine photosensible située sur le substrat, évidée localement au moins au niveau de la surface active du dispositif à ondes de surface et recouvrant les premiers plots conducteurs internes;
- un circuit imprimé recouvrant l'ensemble de la première couche, ledit circuit imprimé comportant des seconds plots conducteurs externes ;
- des vias conducteurs traversant l'ensemble première couche/circuit imprimé et reliant les premiers plots conducteurs internes aux seconds plots conducteurs externes.

Avantageusement, les vias réalisés dans la première couche permettent de réaliser des connexions électriques entre le DOS et le micro-capot constitué par le circuit imprimé, de manière à assurer les plages de report du composant.

De plus la résine constitutive de la première couche, peut avantageusement remplacer localement le dépôt d'absorbant acoustique.

La hauteur du module est réduite à l'épaisseur du circuit imprimé pouvant typiquement être de l'ordre de 25 à 100 microns, à l'épaisseur de la première couche pouvant typiquement être de l'ordre de quelques dizaines de microns et à l'épaisseur du substrat piézoélectrique (quelques centaines de microns).

L'invention a aussi pour objet un procédé de fabrication collective de composants comprenant la réalisation de dispositif à ondes de surface sur un substrat piézoélectrique, et comportant les étapes suivantes :
- la réalisation d'une première couche en résine photosensible et évidée sur l'ensemble des dispositifs à ondes de surface ;
- le collage d'un circuit imprimé sur ladite première couche ;
- la réalisation de vias traversant le circuit imprimé et la première couche au niveau des premiers plots conducteurs internes des dispositifs à ondes de surface ;
- la métallisation des vias et la définition de seconds plots conducteurs externes, lesdits seconds plots étant reliés auxdits premiers plots par les vias métallisés ;
- la découpe de l'ensemble substrat/première couche/circuit imprimé, de manière à dissocier les composants à ondes de surface.

La couche évidée peut être obtenue par dépôt préalable d'une couche uniforme, puis gravure ou bien par laminage d'une couche préalablement évidée ou bien encore par sérigraphie.

Avantageusement, la première couche peut présenter des propriétés d'absorbants acoustiques.

Dans le cadre de la fabrication de dispositifs à ondes de surface, le procédé de l'invention présente l'avantage d'être un procédé collectif sur un substrat piézoélectrique, ce qui entraîne une importante réduction de coût. De plus, un tel procédé collectif est compatible avec les technologies habituellement utilisées pour les semiconducteurs (utilisation de résine de masquage, procédé de photolithographie).

L'invention sera mieux comprise et d'autres avantages apparaîtront à la lecture de la description qui va suivre, donnée à titre non limitatif et grâce aux figures annexées parmi lesquelles :
- les figures 1 et 2 illustrent des dispositifs à ondes de surface, encapsulés selon des techniques de l'art connu ;
- la figure 3 illustre un module de DOS encapsulé ;
- les figures 4a-4g illustrent les principales étapes du procédé collectif de fabrication de DOS encapsulés selon l'invention.

De manière générale, le dispositif à ondes de surface peut être un transducteur, un résonateur comportant au moins un réseau et un transducteur. Dans tous les cas, il est obtenu par dépôt d'électrodes à la surface d'un substrat piézoélectrique. Pour permettre la propagation des ondes de surface, on cherche alors à créer une cavité libre au-dessus des électrodes correspondant à la surface active du composant. Tout en étant très compact, le composant de l'invention permet de préserver la cavité libre comme l'illustre la figure 3. Le substrat piézoélectrique 13 comporte en surface des électrodes non représentées au niveau de la surface dite active 14. La surface active est isolée de l'extérieur par la première couche 11 qui repose sur le substrat piézoélectrique. Un circuit imprimé 12 assure l'étanchéité en face supérieure. Dans le schéma ici représenté un transducteur comportant deux plots internes d'alimentation électrique 111 et 112, peut être connectés depuis l'extérieur par l'intermédiaire des plots supérieurs externes 171 et 172 et des vias conducteurs traversant à la fois le circuit imprimé et la première couche. Dans le cas d'un composant plus complexe devant être alimenté par plus de deux sources, le nombre de via et de plots peut être ajusté de manière adéquat. Le composant à ondes de surface active 14 peut être considéré comme encapsulé dans un boîtier défini à la fois par le substrat piézo-électrique, la première couche 11 et le circuit imprimé 12.

Nous allons ci-après décrire plus en détail les étapes d'un exemple de procédé collectif permettant d'obtenir les composants de l'invention.

### Le circuit imprimé

Un circuit imprimé de type laminé cuivré, imprégné de résine polyimide ou époxy à base de fibres aramides non tissées peut être employé. La face métallisée est utilisée pour la définition ultérieure des vias: La nature du circuit imprimé à savoir des fibres organiques, permet au matériau ainsi renforcé de combiner une bonne stabilité dimensionnelle et un faible coefficient de dilatation thermique dans le plan avec une faible permittivité et une faible rugosité de surface. Enfin, les fibres d'aramides sont compatibles avec le perçage et la métallisation de trous de petites dimensions.

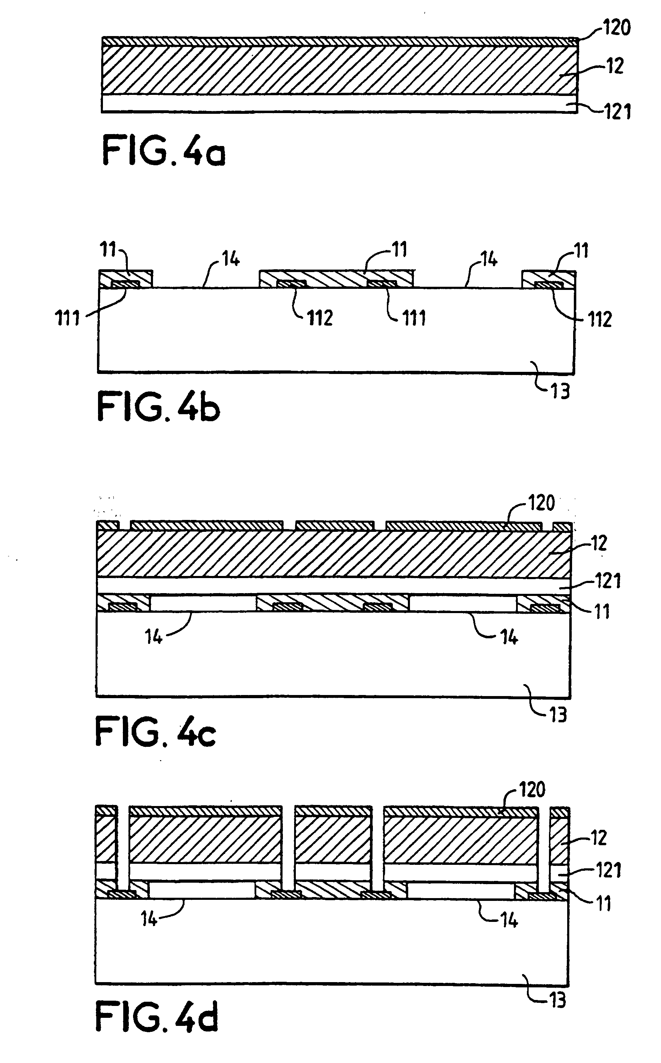

De préférence, le circuit imprimé comprend sur la face opposée à la face métallisée, une seconde couche d'adhésif isolant qui peut être préencollé. La figure 4a illustre les trois couches constitutives du circuit imprimé utilisé dans l'invention, la couche métallique 120, le circuit imprimé 12 et la couche d'adhésif 121.

### Réalisation des cavités au-dessus des surfaces actives des DOS

Une résine constitutive de la première couche 11 de type résine époxy photosensible est déposée à la tournette par centrifugation sur le substrat piézo-électrique. Après un recuit, la résine est photoimagée, puis subit un deuxième recuit. Après développement, le substrat puis la résine, sont étuvées. La figure 4b illustre le substrat piézo-électrique 13 comportant des DOS dont les surfaces actives 14 sont dégagées de résine 11. La résine demeure ailleurs et notamment sur les plots conducteurs internes des DOS 111 et 112. Pour des facilités de représentation, seuls deux DOS sont représentés mais le substrat piézoélectrique en comporte tout un ensemble.

### Collage du circuit imprimé sur la couche 11

Il s'agit plus précisément d'une étape de pressage du circuit schématisé en figure 4a, sur le substrat comportant localement la résine et schématisé en figure 4b. Les deux éléments sont pressés à chaud, par exemple en autoclave. Typiquement, le cycle thermique est adapté, afin de libérer les contraintes des matériaux en présence et éviter les chocs thermiques.

### Réalisation de la connectique

### Gravure de la couche conductrice 120, pour réaliser les vias

Après une préparation de surface de la couche, typiquement du cuivre (dégraissage, microattaque) permettant d'augmenter la rugosité du cuivre et donc l'adhérence, une résine photosensible est déposée à la tournette par centrifugation, sur la couche cuivrée 120. La résine est insolée à la verticale des vias ; avec un photoinsolateur. Le temps d'insolation est fonction de l'épaisseur de résine. Le cuivre non protégé par la résine est dissous par exemple dans une solution ammoniacale. La résine est alors retirée par exemple à l'aide d'acétone et d'alcool. Un masque est ainsi défini dans la couche 120 (figure 4c).

### Ablation de l'ensemble circuit imprimé/couche adhésive/résine, au travers du masque en cuivre

La réalisation des vias au travers de l'ensemble peut être réalisée par exemple au laser excimère ou CO₂, puis terminée par exemple par gravure RIE (« Reactive lonic Etching ») au plasma oxygène. Les vias sont illustrés en figure 4d.

### Métallisation de la surface du substrat et des vias

Après ablation des vias, le masque de cuivre peut éventuellement être gravé. On procède ensuite à la métallisation du circuit par pulvérisation par exemple. Une couche de chrome puis de cuivre 122, par exemple, de quelques microns d'épaisseur sont déposées uniformément sur toute la surface du circuit imprimé et à l'intérieur des trous. Le cycle réalisé dans le bâti utilisé de pulvérisation peut typiquement être le suivant :
- un plasma d'argon pour attaquer mécaniquement la fine couche d'oxyde natif d'aluminium si besoin est ;
- une pulvérisation de chrome : la couche de chrome joue le rôle de couche barrière ;
- une pulvérisation de cuivre.

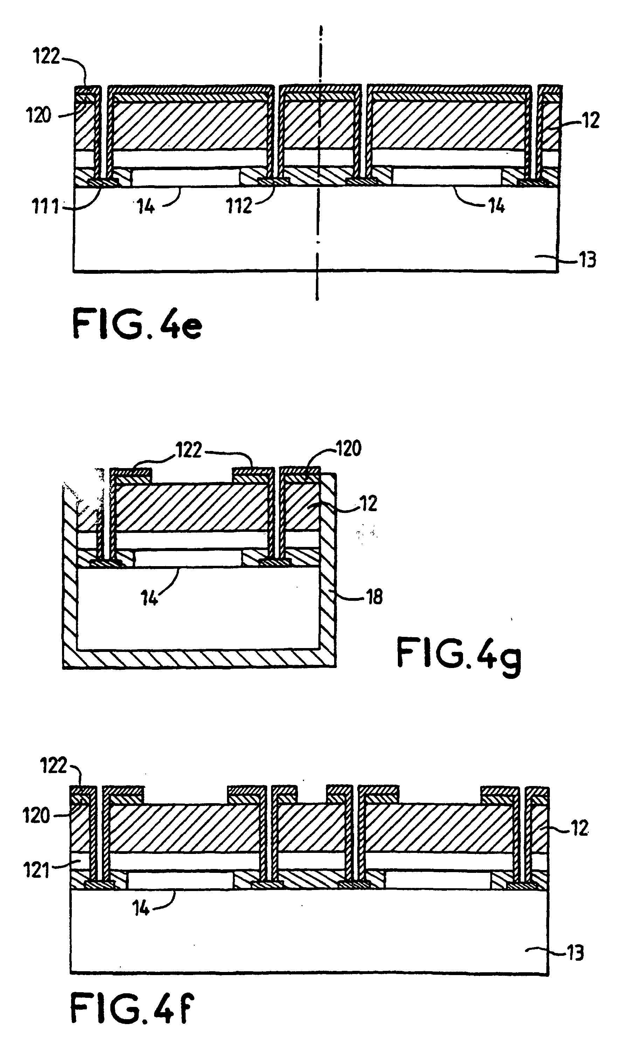

On peut procéder ensuite à une recharge électrolytique de cuivre pour augmenter l'épaisseur de la métallisation à quelques dizaines de microns et assurer ainsi une meilleure stabilité thermomécanique des vias (figure 4e).

### Réalisation des plots conducteurs externes

On dispose sur toute la surface conductrice (substrat + vias), une résine photosensible. La résine est insolée à la verticale des plots externes avec un photoinsolateur de manière à laisser de la résine sur des plots conducteurs externes encore dénommés « pastilles » autour des vias et de la résine se conformant aux parois des vias (dans le cas d'une résine positive).

Le cuivre non protégé par la résine est gravé chimiquement, la résine est alors retirée par exemple à l'aide d'acétone et d'alcool.

On obtient ainsi de manière collective, l'ensemble des composants encapsulés, avec les plots externes de connexions comme illustrés en figure 4f.

### Découpe des composants individuels

On procède enfin à la découpe mécanique des composants. On peut procéder au dépôt d'une troisième couche 18 assurant l'herméticité de l'ensemble avec les propriétés diélectriques qui conviennent comme illustré en figure 4g. Cette couche peut être obtenue par pulvérisation métallique, un dépôt de couche mince d'un matériau conducteur ou diélectrique, par un dépôt d'un vernis ou par coulage de résine ou bien encore par dépôt en phase vapeur d'un polymère de type parylène. L'intérêt de ces méthodes réside dans le fait qu'aussi bien la face inférieure du substrat, que les flancs du composant préalablement réalisé peuvent ainsi être recouverts.

Cette protection peut être une protection mécanique, de support au marquage, de blindage électromagnétique et/ou de protection à l'environnement de type herméticité.

## Revendications

1. Composant à ondes de surface, comprenant au moins un dispositif à ondes de surface encapsulé dans un boîtier, ledit dispositif étant réalisé à la surface d'un substrat piézo-électrique (13) au moyen d'électrodes interdigitées alimentées par des premiers plots conducteurs internes (111,112) à la surface du substrat, **caractérisé en ce que** le boîtier comporte, outre le substrat :
- une première couche (11) en résine photosensible située sur le substrat, évidée localement au moins au niveau de la surface active (14) du dispositif à ondes de surface et recouvrant les premiers plots conducteurs internes ;
- un circuit imprimé (12) recouvrant l'ensemble de la première couche, ledit circuit imprimé comportant des seconds plots conducteurs externes (171,172) ; et
- des vias conducteurs traversant l'ensemble première couche/circuit imprimé et reliant les premiers plots conducteurs internes aux seconds plots conducteurs externes.

2. Composant à ondes de surface selon la revendication 1, **caractérisé en ce que** le boîtier comprend une seconde couche (121), dite couche d'adhésif située entre la première couche et le circuit imprimé.

3. Composant à ondes de surface selon l'une des revendications 1 à 2, **caractérisé en ce que** la face externe du substrat et les faces latérales du composant sont recouverts d'une troisième couche (18), hermétique.

4. Composant à ondes de surface selon l'une des revendications 1 à 3, **caractérisé en ce que** le circuit imprimé est métallisé en surface.

5. Composant à ondes de surface selon l'une des revendications 1 à 4, **caractérisé en ce que** la première couche a des propriétés d'absorbant acoustique.

6. Procédé de fabrication collective de composants à ondes de surface selon l'une des revendications 1 à 5, comprenant la réalisation de dispositifs à ondes de surface sur un substrat piézoélectrique (13), et :
- la réalisation d'une première couche (11) en résine photosensible évidée sur l'ensemble des dispositifs à ondes de surface ;
- le collage d'un circuit imprimé (12) sur ladite première couche ;
- la réalisation de vias traversant le circuit imprimé et la première couche au niveau des premiers plots conducteurs (111,112) internes des dispositifs à ondes de surface ;
- la métallisation des vias et la définition de seconds plots conducteurs externes (171,172), lesdits seconds plots étant reliés auxdits premiers plots par les vias métallisés ; et
- la gravure de l'ensemble substrat/première couche/circuit imprimé de manière à dissocier les composants à ondes de surface.

7. Procédé de fabrication collective de composants, selon la revendication 6, **caractérisé en ce que** la réalisation de la première couche évidée est obtenue par dépôt préalable d'une couche uniforme, suivi de la gravure de ladite couche.

8. Procédé de fabrication collective de composants, selon la revendication 6, **caractérisé en ce que** la réalisation de la première couche évidée est obtenue par laminage d'une couche préalablement évidée.

9. Procédé de fabrication collective de composants selon l'une des revendications 6 à 8, **caractérisé en ce que** le collage du circuit imprimé sur la première couche comprend :
- le dépôt d'une seconde couche (121), dite couche d'adhésif sur le circuit imprimé ;
- le pressage à chaud du circuit imprimé/seconde couche sur l'ensemble première couche/substrat piézoélectrique.

10. Procédé de fabrication collective de composants selon l'une des revendications 6 à 9, **caractérisé en ce qu'**il comprend la réalisation d'une troisième couche (18), dite couche d'enrobage sur la face inférieure du substrat et sur les faces latérales du composant.

11. Procédé de fabrication collective selon la revendication 10, **caractérisé en ce que** la troisième couche est réalisée par pulvérisation.

12. Procédé de fabrication collective selon la revendication 10, **caractérisé en ce que** la troisième couche est réalisée par dépôt en phase vapeur d'un polymère de type parylène.

13. Procédé de fabrication collective selon la revendication 10, **caractérisé en ce que** la troisième couche est obtenue par dépôt d'un vernis.

## Patentansprüche

1. Oberflächenwellenbauelement, das mindestens eine Oberflächenwellenvorrichtung aufweist, die in ein Gehäuse eingekapselt ist, wobei die Vorrichtung an der Oberfläche eines piezoelektrischen Substrats (13) mit Hilfe von ineinander verzinkten Elektroden hergestellt wird, die von ersten inneren leitenden Kontaktpunkten (111, 112) an der Oberfläche des Substrats gespeist werden, **dadurch gekennzeichnet, dass** das Gehäuse außer dem Substrat aufweist:
- eine erste, auf dem Substrat befindliche Schicht (11) aus lichtempfindlichem Harz, die lokal mindestens in Höhe der aktiven Fläche (14) der Oberflächenwellenvorrichtung ausgespart ist und die ersten inneren leitenden Kontaktpunkte bedeckt;
- eine gedruckte Schaltung (12), die die Gesamtheit der ersten Schicht bedeckt, wobei die gedruckte Schaltung zweite äußere leitende Kontaktpunkte (171, 172) aufweist; und
- leitende Lücken, die die aus der ersten Schicht und der gedruckten Schaltung bestehende Einheit durchqueren und die ersten inneren leitenden Kontaktpunkte mit den zweiten äußeren leitenden Kontaktpunkten verbinden.

2. Oberflächenwellenbauelement nach Anspruch 1, **dadurch gekennzeichnet, dass** das Gehäuse eine zweite, sogenannte Kleberschicht (121) aufweist, die sich zwischen der ersten Schicht und der gedruckten Schaltung befindet.

3. Oberflächenwellenbauelement nach einem der Ansprüche 1 bis 2, **dadurch gekennzeichnet, dass** die Außenfläche des Substrats und die Seitenflächen des Bauelements mit einer dritten, hermetisch dichten Schicht (18) bedeckt sind.

4. Oberflächenwellenbauelement nach einem der Ansprüche 1 bis 3, **dadurch gekennzeichnet, dass** die gedruckte Schaltung an der Oberfläche metallisiert ist.

5. Oberflächenwellenbauelement nach einem der Ansprüche 1 bis 4, **dadurch gekennzeichnet, dass** die erste Schicht schallabsorbierende Eigenschaften aufweist.

6. Verfahren zur kollektiven Herstellung von Oberflächenwellenbauelementen nach einem der Ansprüche 1 bis 5, das die Herstellung von Oberflächenwellenvorrichtungen auf einem piezoelektrischen Substrat (13) und:
- die Herstellung einer ersten ausgesparten Schicht (11) aus lichtempfindlichem Harz über der Gesamtheit der Oberflächenwellenvorrichtungen;
- das Kleben einer gedruckten Schaltung (12) auf die erste Schicht;
- die Herstellung von Lücken, die die gedruckte Schaltung und die erste Schicht in Höhe der ersten inneren leitenden Kontaktpunkte (111, 112) der Oberflächenwellenvorrichtungen durchqueren;
- die Metallisierung der Lücken und die Definition von zweiten äußeren leitenden Kontaktpunkten (171, 172), wobei die zweiten Kontaktpunkte mit den ersten Kontaktpunkten über die metallisierten Lücken verbunden sind; und
- das Gravieren der Einheit aus Substrat, erster Schicht und gedruckter Schaltung derart, dass die Oberflächenwellenbauelemente getrennt werden,
aufweist.

7. Verfahren zur kollektiven Herstellung von Bauelementen nach Anspruch 6, **dadurch gekennzeichnet, dass** die Herstellung der ersten ausgesparten Schicht durch vorhergehendes Aufbringen einer gleichmäßigen Schicht, gefolgt vom Gravieren dieser Schicht, erfolgt.

8. Verfahren zur kollektiven Herstellung von Bauelementen nach Anspruch 6, **dadurch gekennzeichnet, dass** die Herstellung der ersten ausgesparten Schicht durch Walzen einer vorher ausgesparten Schicht erfolgt.

9. Verfahren zur kollektiven Herstellung von Bauelementen nach einem der Ansprüche 6 bis 8, **dadurch gekennzeichnet, dass** das Kleben der gedruckten Schaltung auf die erste Schicht umfasst:
- das Aufbringen einer zweiten, sogenannten Kleberschicht (121) auf die gedruckte Schaltung;
- das Warmpressen der gedruckten Schaltung/zweiten Schicht auf die Einheit aus erster Schicht und piezoelektrischem Substrat.

10. Verfahren zur kollektiven Herstellung von Bauelementen nach einem der Ansprüche 6 bis 9, **dadurch gekennzeichnet, dass** es die Herstellung einer dritten, sogenannten Umhüllungsschicht (18) auf der Unterseite des Substrats und den Seitenflächen des Bauelements aufweist.

11. Verfahren zur kollektiven Herstellung nach Anspruch 10, **dadurch gekennzeichnet, dass** die dritte Schicht durch Zerstäuben hergestellt wird.

12. Verfahren zur kollektiven Herstellung nach Anspruch 10, **dadurch gekennzeichnet, dass** die dritte Schicht durch Aufbringen eines Polymers vom Typ Parylen in der Dampfphase hergestellt wird.

13. Verfahren zur kollektiven Herstellung nach Anspruch 10, **dadurch gekennzeichnet, dass** die dritte Schicht durch Aufbringen eines Lacks erhalten wird.

## Claims

1. Surface-wave component, comprising at least one surface-wave device encapsulated in a package, the said device being produced on the surface of a piezoelectric substrate (13) by means of interdigitated electrodes supplied via internal first conducting pads (111, 112) on the surface of the substrate, **characterized in that** the package comprises, in addition to the substrate:
- a first layer (11) of photoresist placed on the substrate and covering the internal first conducting pads, said layer being locally recessed at least down to the level of the active surface (14) of the surface-wave device;
- a printed circuit (12) covering the entire first layer, the said printed circuit having external second conducting pads (171, 172); and
- conducting vias passing through the first layer/printed circuit assembly and connecting the internal first conducting pads to the external second conducting pads.

2. Surface-wave component according to Claim 1, **characterized in that** the package includes a second layer (121) called adhesive layer, located between the first layer and the printed circuit.

3. Surface-wave component according to either of Claims 1 and 2, **characterized in that** the external face of the substrate and the lateral faces of the component are covered with a hermetic third layer (18).

4. Surface-wave component according to one of Claims 1 to 3, **characterized in that** the printed circuit is surface-metallized.

5. Surface-wave component according to one of Claims 1 to 4, **characterized in that** the first layer has acoustic absorption properties.

6. Process for the collective fabrication of surface-wave components according to one of Claims 1 to 5, comprising the production of surface-wave devices on a piezoelectric substrate (13) and:
- the formation of a first layer (11) of photoresist, recessed on all the surface-wave devices;
- the bonding of a printed circuit (12) to the said first layer;
- the formation of vias passing through the printed circuit and the first layer at the internal first conducting pads (111, 112) of the surface-wave devices;
- the metallization of the vias and the definition of external second conducting pads (171, 172), the said second pads being connected to the said first pads by the plated-through vias; and
- the etching of the substrate/first layer/printed circuit assembly so as to separate the surface-wave components.

7. Process for the collective fabrication of components according to Claim 6, **characterized in that** the recessed first layer is formed by the prior deposition of a uniform layer followed by the etching of the said layer.

8. Process for the collective fabrication of components according to Claim 6, **characterized in that** the recessed first layer is formed by laminating a pre-recessed layer.

9. Process for the collective fabrication of components according to one of Claims 6 to 8, **characterized in that** the bonding of the printed circuit to the first layer comprises:
- the deposition of a second layer (121), called the adhesive layer, on the printed circuit; and
- the hot-pressing of the printed circuit/second layer onto the first layer/piezoelectric substrate assembly.

10. Process for the collective fabrication of components according to one of Claims 6 to 9, **characterized in that** it includes the formation of a third layer (18), called the encapsulating layer, on the inner face of the substrate and on the lateral faces of the component.

11. Collective fabrication process according to Claim 10, **characterized in that** the third layer is formed by spraying.

12. Collective fabrication process according to Claim 10, **characterized in that** the third layer is formed by vapour deposition of a parylene-type polymer.

13. Collective fabrication process according to Claim 10, **characterized in that** the third layer is obtained by depositing a varnish.
